# EUROPEAN PATENT APPLICATION

(11) **EP 4 604 179 A1**
(43) Date of publication of application: **20.08.2025**
(21) Application number: 25152258.7
(22) Date of filing: 16.01.2025
(51) Int. Cl.: H01L 23/48, H01L 25/065, H01L 21/56

(54) **DEVICE PACKAGES WITH PARTIALLY MOLDED CONNECTORS**

(30) Priority: 13.02.2024 US 202418440207
(71) Applicant: NXP USA, Inc., Austin, TX 78735 (US)
(72) Inventor: Shah, Ankur Shailesh, 5656AG Eindhoven (NL); Vincent, Michael B, 5656AG Eindhoven (NL); Southworth, Paul, 5656AG Eindhoven (NL)
(74) Representative: Colaiuda, Antonella

(57) **Abstract**

A connector body such as a coaxial electrical connectors or fiber optic connector can be mounted above a device die that is encapsulated with molding material forming part of a molded device package by bonding the connector body to a redistribution structure formed on the device die. After the device die is molded, a lower portion of the connector body is surrounded by the molding material and an upper portion of the connector body is exposed at an exterior surface of the package. The redistribution structure can be configured to couple connector body to the device while preventing unwanted mechanical stress on the connector body and the device die.

## Description

### TECHNICAL FIELD

Embodiments of the disclosure are related to electronic device packages which are at least partially formed by polymeric materials which encapsulate one or more components within the package.

### BACKGROUND

Devices such as semiconductor integrated circuits are frequently encapsulated within molded polymer device packages which can protect the devices from mechanical damage and undesired contact with an external environment while providing macroscopic electrical contacts on one or more external surfaces of the package to allow for devices within the package to be interconnected with other devices. Such packages can incorporate carrier substrates such as printed circuit boards and can completely or partially encapsulate carrier substrates and semiconductor components. Some device packages include signal connectors configured to receive an electrical or other cable. Such connectors can include standard electrical connectors such as sub-miniature A (SMA), sub-miniature B (SMB), type N, and type F receptacles or corresponding plugs and can be integrated into device packages by mounting a connector on pads exposed at the surface of a device package (e.g., via surface-mount soldering techniques). Alternatively, a connector can be mounted directly on a surface of semiconductor die provided with suitable contact pads or mounted on a printed circuit board or other carrier substrate adjacent to one or more semiconductor device die or other components.

### BRIEF SUMMARY

In an example embodiment, an electronic device package includes a device die having an upper surface and a lower surface, and a redistribution structure disposed on the upper surface of the device die. The redistribution structure includes one or more redistribution layers (RDLs) formed from electrically insulating material and having electrical interconnects routed within them. The package also includes a connector body disposed above the die and bonded to the redistribution structure. A volume of molding material encapsulates the die and the redistribution structure and surrounds a lower portion of the connector body such that an upper portion of the connector body is exposed at a surface of the device package.

In another example embodiment, a method includes bonding a connector body to a redistribution structure above a device die. The connector body is an electrical connector configured to be coupled to a coaxial electrical cable or a fiber optic connector configured to be coupled to an optical fiber. The redistribution structure includes one or more redistribution layers (RDLs) formed from electrically insulating material and having electrical interconnects routed within them. The method further includes encapsulating the device die and the redistribution structure within a volume of molding material such that a lower portion of the connector body is surrounded by the volume of molding material and the upper portion of the connector body is exposed at a surface of the device package.

### BRIEF DESCRIPTION OF THE SEVERAL VIEWS OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1A is a cross-sectional view of an example device package according to one or more embodiments;
FIG. 1B is a cross-sectional view showing a portion of the package of FIG. 1A in greater detail;
FIG. 2 is a cross-sectional view of an example device package according to one or more embodiments that is related to the device package of FIG. 1A;
FIG. 3 is a process flow illustration depicting an example process according to one or more embodiments suitable for forming the device package of FIG. 1A;
FIG. 4 is a cross-sectional view of another example device package according to one or more embodiments;
FIG. 5 is a cross-sectional view of another example device package according to one or more embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention. The connecting lines shown in the various figures contained herein are intended to represent exemplary functional relationships and/or physical couplings between the various elements. It should be noted that many alternative or additional functional relationships or physical connections may be present in one or more embodiments of the subject matter. Directional references such as "top," "bottom," "left," "right," "above," "below," and so forth, unless implied or stated otherwise, are not intended to require any preferred orientation, and are made with reference to the orientation of the corresponding figure or figures for purposes of illustration.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

It will be appreciated that the steps of various processes described herein are non-limiting examples of suitable processes according to embodiments and are for the purposes of illustration. Embodiments herein may use any suitable processes including those that omit steps of example processes described herein, perform those steps or similar steps in different orders, and the like. It will also be appreciated that well-known techniques and features may be omitted for clarity.

Unless explicitly stated otherwise, the terms "approximately" and "substantially", when used herein to refer to measurable quantities including, but not limited to dimensions, shall mean that a quantity is equal to a stated value or that two quantities are equal to each other to within an amount determined by accepted tolerances of the process(es) chosen to fabricate the relevant structure and/or an accepted measurement accuracy of the method(s) and/or measurement device(s) chosen to measure the dimensions or other properties described.

Conventional approaches for integrating macroscopic cable connectors with molded device packages include attaching connectors to the exterior of a package or bonding a connector to an otherwise unoccupied area of a carrier substrate such as a printed circuit board. However, such approaches can have disadvantages. As one example, connectors which are bonded to the exterior of a molded package can be susceptible to mechanical damage. In addition, lengthy electrical interconnections may be required to couple the connector to devices within the package which can degrade performance by introducing unwanted signal attenuation. In other approaches a connector may is disposed adjacent to one or more components on a printed circuit board or other substrate and the connector is partially molded together with the components on the substrate. However, such approaches can significantly increase the minimum footprint of the package. Accordingly, embodiments disclosed herein provide electronic device packages that include integrated signal connectors which can disposed directly above or below components within the package while providing strain relief which protects the connector and the die from unwanted mechanical stresses which can lead to device damage and/or degraded electrical performance while also reducing the minimum footprint area of the package compared to other approaches.

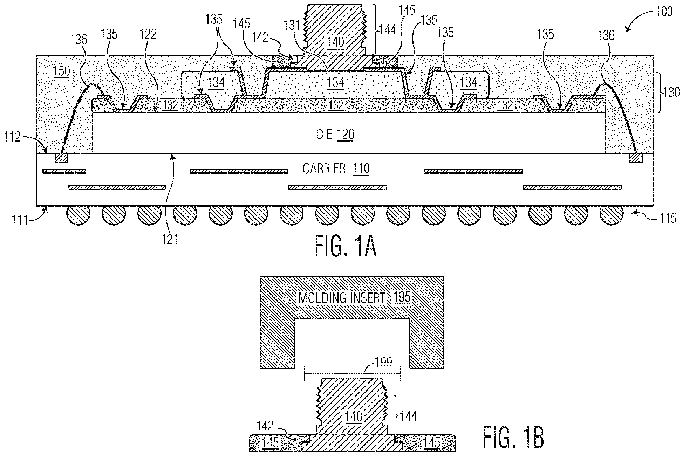

FIG. 1A is a cross-sectional view of an example package according to one or more embodiments that includes an integrated connector body, non-limiting examples of which include coaxial electrical cable connectors such as SMA, SMB, type N, or type F receptacles and plugs. The package 100 includes a carrier substrate (the carrier 110; e.g., a printed circuit board or any other suitable substrate) that has a lower surface 111 and an upper surface 112. The carrier 110 can include electrical contacts (represented by solder bumps 115) on its lower surface 111 that are suitable for use in coupling the carrier 110 to another assembly or device. A semiconductor device die or other electronic device die (the die 120 which has a lower surface 121 and an upper surface 122) is bonded to the carrier 110 using any suitable material and process(es) including but not limited to soldering, direct bonding, adhesive bonding using electrically conductive or nonconductive adhesives, and the like. A die such as the die 120 and/or a connector body such as the connector body 140 can be electrically coupled to a carrier substrate such as the carrier 110 using any suitable methods, including but not limited to the use of wire bonds 136 as shown in FIG. 1A. The carrier 110 includes electrical contacts (represented by solder bumps 115) on its lower surface 111 that are suitable for use in coupling the carrier 110 to another assembly or device. It will be appreciated that, in one or more embodiments, a die such as the die 120 may be provided with electrical contacts on its bottom surface and can form an exposed surface of a device package without requiring a carrier substrate such as the carrier 110. A die such as the die 120 can also be mechanically coupled to a carrier such as the carrier 110 using any suitable materials and methods including, but not limited to adhesive bonding using epoxy-based materials or other polymeric materials.

The package 100 includes a redistribution structure 130 that is disposed on the upper surface 122 of the die 120. The redistribution structure 130 includes one or more redistribution layers. A redistribution layer (RDL) is a layer of insulating material through which electrically conductive interconnects 135 are routed. Interconnects such as the interconnects 135 can be used for various purposes including, but not limited to, electrically coupling portion of the die 120 to each other and to electrical contacts or other structures on or within the carrier 110. A connector body 140 is disposed on an upper surface the redistribution structure 130 (the upper RDL surface 131) and coupled to the die 120 via one or more interconnects 135. Electrical connections to the connector body 140 formed by interconnects 135 can also mechanically couple the connector body 140 to the redistribution structure 130. The redistribution structure 130 can allow the connector body 140 to be indirectly mechanically coupled to the die 120 in order to avoid unwanted mechanical stresses which might otherwise be experienced by the die 120 and/or the connector body 140 due to mismatches in thermal expansion between the connector body 140 and the die 120 or stresses which would otherwise be experienced when bonding the connector body 140 directly to the upper surface 122 of the die 120.

In one or more embodiments, as shown in the example of FIG. 1A, a redistribution structure such as redistribution structure 130 includes a first RDL such as the first RDL 132 and a second RDL such as the RDL 134. In one or more such embodiments, the first RDL is characterized by a first elastic modulus and the second RDL is characterized by a second elastic modulus that is lower than the first elastic modulus. It will be appreciated that the relative thickness and elastic moduli of RDLs in a redistribution structure according to embodiments herein can be chosen to realize a desired combination of stiffness and mechanical compliance. It will be further appreciated that a redistribution structure according to embodiments herein can include any suitable number of RDLs in any suitable arrangement. In one or more embodiments, a first RDL such as the RDL 132 has a thickness less than 10 µm and a second RDL such as the RDL 134 has a thickness of greater than 10 µm. In one such embodiment, the first RDL has a thickness in the inclusive range of 3-5 µm and the second RDL has a thickness greater than 20 µm. It will also be understood that, in one or more embodiments, a connector body such as the connector body 140 can be bonded directly to suitable features such as contact pads on a die such as the die 120 without a redistribution structure such as the redistribution structure 130.

In one or more embodiments a single RDL (e.g., the first RDL 132 or RDL 134) is used between the die and the connector body. In such embodiments, suitable materials for the RDL include, but are not limited to, polyimide-based materials with a thickness of at least 6 µm (e.g., photosensitive polyimide films with a thickness in the inclusive range of 6-20µm). For some applications, it is desirable that the modulus of such materials be approximately 3 GPa and that the cured film should have a breakdown voltage of approximately 100 V/µm or better.

In the example of FIG. 1A, the connector body 140 includes lower portion 142 and an upper portion 144. The lower portion 142 is encapsulated, along with the redistribution structure 130, the die 120 and (at least) the upper surface 112 of the carrier 110 within a volume of molding material 150 which may be any suitable electrically-insulating polymeric material including, but not limited to an epoxy-based material. The molding material 150 may be formed as shown using any suitable methods. As one non-limiting example, the volume of molding material 150 is formed using a film-assisted molding process in which a molding insert protects the upper portion 144 of the connector body 140 from being molded, leaving it exposed as shown in FIG. 1A at the surface 151 of the volume of molding material which forms a first exterior surface of the package 100, with an opposite exterior surface of the package 100 formed by the lower surface 111 of the carrier 110.

It will be appreciated that the connector body 140 is described as an electrical connector for purposes of illustration and that other connectors can be used. For example, in one or more embodiments, a connector body such as the connector body 140 is a fiber optic connector configured to be coupled to an optical fiber, non-limiting examples of which include an SC fiber connector, FC fiber connector, LC fiber connector, ST fiber connector and the like. In one or more such embodiments, a package such as the package 100 includes optoelectronic components configured to be coupled to the connector body and the package can include optical elements such as waveguides, lenses, and optical couplers, as non-limiting examples. Such components can be formed with one or more RDL layers of a redistribution structure such as the redistribution structure 130, and/or on or within a die such as the die 120, as non-limiting examples.

It will be further appreciated that RDLs such as the RDL 132 and the RDL 134, along with interconnects 135 are depicted schematically for ease of understanding. For example, the relative dimensions of interconnects within RDLs and the relative dimensions of RDLs with respect to other features may be exaggerated for clarity. It will be understood that horizontal portions of interconnects such as the interconnects 135 and related interconnects described herein may be disposed on surfaces of one or more RDLs and that the thickness of such interconnects may be significantly less than the thickness(es) of the RDL(s) such that height variations corresponding to interconnects along the RDL surfaces may be small compared to the thickness(es) of the corresponding RDL(s).

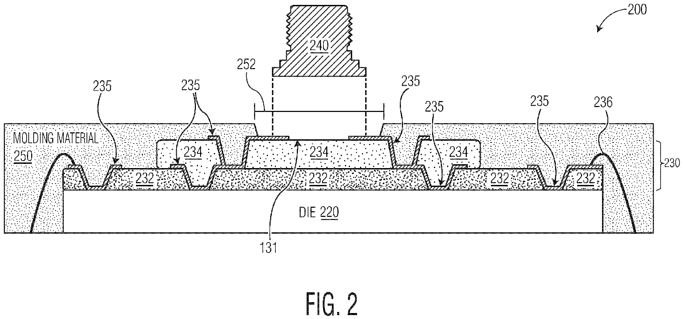

FIG. 1B shows a detailed view of the connector body 140 of FIG. 1A. In the example of FIG. 1B, the connector body 140 includes extensions 145 surrounding the lower portion 142 of the connector body 140. Such extensions can enable the use of film-assisted molding (FAM) to form the volume of molding material 150 if dimensions of the connector body 140 are too small to support a molding insert during film-assisted model. For example, the width of the base of a connector body such as the connector body 140 may be less than a minimum clearance (as represented by the dimension 199) required for a molding insert such as the molding insert 195 as shown in FIG. 1B. It will be appreciated that relative dimensions of the connector body 140 and the extensions 145 are not to scale and may differ from other depictions as an aid to understanding. Extensions such as the extensions 145 can be formed in any suitable manner, using any suitable materials. For example, the extensions 145 can be formed by dispending and curing epoxy at connector base, injection molding, or another suitable process. In one or more embodiments, a connector body such as the connector body 140 can be bonded to a redistribution structure such as the redistribution structure 130 followed by formation of extensions such as the extensions 145 or in one or more other embodiments, the connector body may be provided with extensions before being bonded to the redistribution structure. It will be further understood that in one or more embodiments (e.g., embodiments described in connection with FIG. 2 below) extensions such as the extensions 145 are not necessary.

FIG. 2 is a partially exploded cross-sectional view of another example package according to one or more embodiments that includes an integrated connector body. The package 200 includes a die 220 (e.g., a die 120) with a lower surface 221 and an upper surface 222 opposite the lower surface 221. A redistribution structure 230 is disposed on the upper surface 221 of the redistribution structure 230 and includes electrically-conductive interconnects 235, similarly to the redistribution structure 130 of FIG. 1A. In this example the redistribution structure 230 includes a first RDL 232 (e.g., a first RDL 132) and a second RDL 234 (e.g., an RDL 134). The package 200 includes an aperture in 252 in the volume of molding material 250 with one or more interconnects 235 exposed on the upper RDL surface 231 of the redistribution structure 230. The connector body 240 can be bonded to the exposed interconnects 235 within the aperture 252 before or after the die 220 and the redistribution structure 230 are encapsulated within the volume of molding material 250.

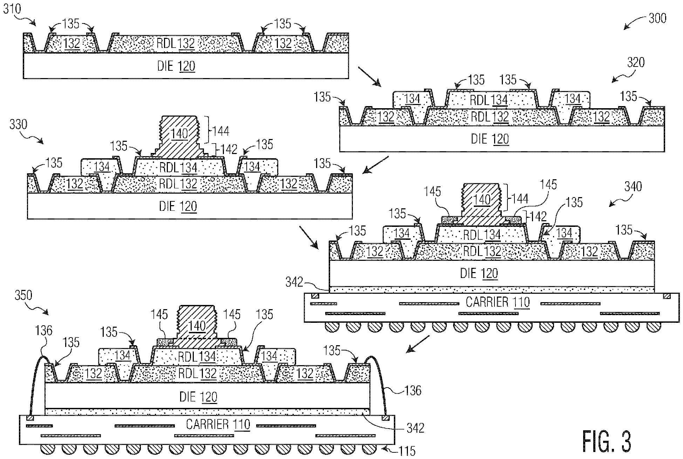

FIG. 3 shows an example process suitable for forming a device package according to one or more embodiments. The process 300 includes the steps 310, 320, 330, 340, and 350 which are described in connection with forming the package 100 of FIG. 1A. It will be appreciated that, for ease of understanding, certain elements may be committed such as descriptions of well-known techniques and fabrication processes. Furthermore, it will be understood that in one or more embodiments steps of the process 300, other processes described herein and/or similar processes may be performed in a different order than described, that steps of the process 300 or other processes, or related steps may be omitted, and that additional steps can be added. It will be further understood that multiple process steps may be described as occurring in a single process step or that actions described as occurring in multiple steps may be performed in a single step.

At step 310, the die 120 is received and the first RDL 132 is formed. The RDL 132 and subsequent RDLs may be formed by any suitable process. As an example, a suitable polymer film may be deposited or otherwise formed on the upper surface 122 of the die 120 followed by formation and patterning of a masking material such as photoresist in photolithographic process. A metal or other suitably conductive material can be deposited via sputtering, thermal evaporation, or a plating process to form a first portion of the interconnects 135, followed by removal of the masking material to remove unwanted material deposited onto the masking material (i.e., an additive "lift-off" process). Alternatively, the interconnects 135 within the first RDL 132 can be patterned in a subtractive process in which metal is deposited over an entire area and then selectively removed (e.g., via wet chemical etching, sputter etching, and/or reactive ion etching, as non-limiting examples). Next at step 320, the RDL 134 is formed and patterned above the RDL 132. It will be understood that, in one or more embodiments, which include only one RDL, that step 320 is omitted.

It will be understood that descriptions of steps such as step 310 above are simplified for ease of understanding. Along these lines, it will be understood that RDLs such as the RDL 132 and the RDL 134 may be formed in multiple steps and interconnects such as interconnect 135 may be formed from multiple metal layers or metal alloy layers in multiple metal deposition steps. As one nonlimiting example, an RDL with embedded interconnects can be formed by depositing a metal seed layer over a die. Photoresist can then be patterned over the seed layer and used as a mask during electroplating of additional metal which can be the same metal as the seed layer or a different metal. The photoresist can then be removed and the residual seed layer can be etched away leaving only the desired interconnect features.

At step 330, the connector body 140 is bonded to the redistribution structure 130 (formed by the RDL 132 and the RDL 134). In one or more embodiments, a connector body such as the connector bod 140 is bonded to a redistribution structure 130 such as the redistribution structure 130 (at least in part) by being bonded to exposed interconnects 135 (i.e., interconnects 135 of the RDL 134) which can also serve to electrically couple signal connections of the connector body to a die such as the die 120. In one or more embodiments, a connector body can also be bonded to a redistribution structure using electrically conductive or electrically nonconductive adhesive.

At step 340, the lower surface 121 of the die 120 is bonded to the carrier 110 using a bonding material 342 such as an adhesive which can be electrically conductive, highly resistive, or nonconducting. At step 340, the extensions 145 are formed around the lower portion 142 of the connector body 140 as described above in connection with FIG. 1B. In one or more embodiments, a connector body such as the connector body 140 is received with extensions such as the extensions 145 already formed, or the extensions are formed during an earlier step (e.g., at step 330), or the extensions 145 are formed at a later step (e.g., the step 350 of the process 300).

At step 350, one or more interconnects 135 are coupled to electrical contacts on the carrier 110 (e.g., by the wire bonds 136), thereby electrically coupling one or more signal lines of the connector body 140 to the die 120. After step 350, a molding process may be performed to encapsulate the die 120, the redistribution structure 130 (i.e., the RDL 132 and the RDL 134) and the lower portion 142 of the connector body 140 within the volume of molding material 150 as shown in FIG. 1A.

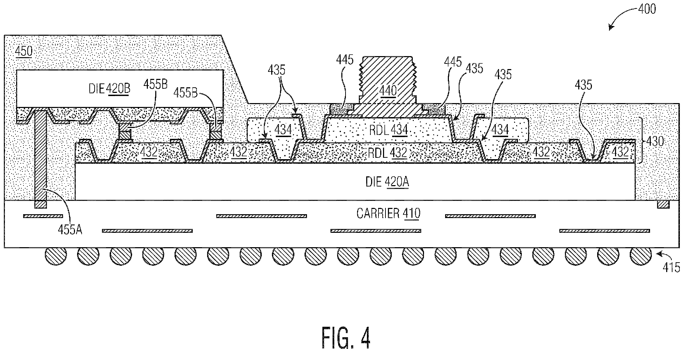

Packages according to embodiments disclosed herein are not limited to a single die such as the die 120 or the die 220. For instance, FIG. 4 is a cross-sectional view of an example device package (the package 400) which includes a first die 420A and a second die 420B in a stacked arrangement with both die encapsulated within a volume of molding material 450 (e.g., molding material 150 or 250). As shown, the die 420A is disposed on a carrier 410 (e.g., a carrier 110) and includes redistribution structure 430 with a first RDL 432 and a second RDL 434. A connector body connector 440 (e.g., a connector body 140 or 240) is bonded to interconnects 435 of the redistribution structure 430.

A die such as the die 420B can include a redistribution structure is similar to the redistribution structure 430. In the example of FIG. 4, additional interconnects 455A and 455B can electrically couple the die 420B to an electrical contact or other structure on the carrier 410, and to die 420A (via interconnects 435 of the redistribution structure 430), respectively. As an example, the through mold interconnects 455A and 455B are depicted as metal pillars which can be directly bonded metallized pads on the carrier 410 or interconnects 435.

A multilayer package with two or more stacked die such as the package 400 can be fabricated using methods related to those described in connection with FIG. 3. In one example, steps 310 through 350 (or steps 310 through 340) of the process 300 can be performed followed by coupling the die 420B to the die 420A and to the carrier 410 via sufficiently-dimensions interconnects 455A, 455B, followed by a molding step to encapsulate the die 420A, 420B as pictured in FIG. 4. The die 420B can be bonded to the die 420A and the carrier 410 prior to molding and the entire package 400 can be molded in a single film assisted molding step in which multiple molding inserts can be used to define the differing thickness of the molding material 450 over the die 420B and surrounding the connector body 440.

It will be understood that the relative thicknesses of the die 420A, 420B and the thickness of the molding material 450 between them are not necessarily to scale and that the interconnects 455A, 455B may be formed from any suitable materials. For example, the interconnects 455A, 455B can be solder bumps or metal pillars of differing heights (i.e., the interconnects 455B are shorter than the interconnect 455A). One or more of the interconnects 455A, 455B can be formed from two different structures which are configured to coalesce together or otherwise adhere to each other during bonding. As one non-limiting example the interconnect 455A shown can be formed by solder bump on the die 420B that fuses during bonding with a corresponding solder bump on the carrier 410. Similarly, one or more of the interconnects 455B can be formed by two corresponding solder bumps. As another non-limiting example, an interconnect 455A or 455B can be formed by a solder bump, a metal pillar, or another related structure on the die 420B or the die 420A and a corresponding volume of adhesive material on the opposite die.

It will be understood that nothing herein is intended to limit packages such as the package 400 to only two die and that any number of die, stacked in any suitable arrangement is possible using the devices and methods disclosed herein as well as other well-known methods including, but not limited to, film-assisted molding and the like. It will be further understood that nothing herein is intended to require that a second die such as the die 420B is electrically or mechanically coupled to both another die such as the die 420A or to a carrier such as the carrier 410.

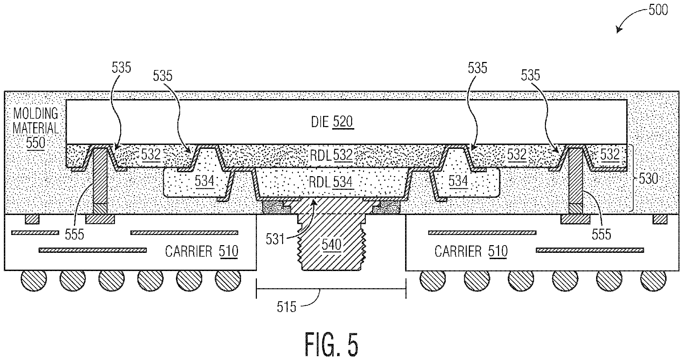

FIG. 5 is a cross-sectional view of another example package according to one or more embodiments. In the package 500, a die 520 (e.g., a die 120, 220, or 420) is encapsulated with a volume of molding material 550 and bonded to a carrier 510 that includes an aperture 515 that allows a connector body 540 (e.g., a connector body 140, 240, or 440) to be oriented "face down" with respect to the carrier 510 such that it can be accessed through the aperture 515 in the carrier 510. As shown, the die 520 is electrically and/or mechanically coupled to suitable contact pads or other structures on the carrier 510 via interconnects 555 (e.g., interconnects 455A or 455B).

A package such as the package 500, in which a connector body is "face down" with respect to a carrier such as the carrier 510 can be fabricated using methods related to those described in connection with FIG. 3. In one example, steps 310 through 330 of the process 300 can be performed. The die 520 can then be bonded "face down" to the carrier 510 via the interconnects 555 such that the connector body 540 protrudes through the aperture 515 in the carrier 510. Afterward a molding process can be performed to encapsulate the die 520 with the volume of molding material 550. In one or more embodiments, a molding insert may be used together with a film assisted molding process to prevent the molding material 550 from filling the aperture 515 in the carrier 510.

### EXAMPLES

Features of embodiments may be understood by way of one or more of the following examples.

Example 1: a device or method in which an electronic device package includes a device die having an upper surface and a lower surface and a redistribution structure disposed on the upper surface of the device die. The redistribution structure includes one or more redistribution layers (RDLs) formed from electrically insulating material and having electrical interconnects routed within them. A connector body is disposed above the die and bonded to the redistribution structure, and a volume of molding material encapsulates the die and the redistribution structure and surrounds lower portion of the connector body such that an upper portion of the connector body is exposed at a first surface of the device package.

Example 2: the device or method of Example 1 where the connector body is an electrical connector configured to be coupled to a coaxial electrical cable.

Example 3: The device or method of Example 1 or Example where the redistribution structure includes a first RDL disposed on the upper surface of the device die and a second RDL disposed between the first RDL and the connector body.

Example 4: the device or method of any of Examples 1-3 where the lower portion of the connector body is encapsulated within the volume of molding material.

Example 5: the device or method of any of Examples 1-4 that further includes a carrier substrate having a lower surface and an upper surface opposite the upper surface; where the lower surface of the device die is bonded to the upper surface of the carrier substrate, where the lower surface of the carrier substrate includes a set of external electrical contacts that are exposed at a second surface of the device package, and where the electrical connector is electrically coupled to one or more of the external electrical interconnects via an electrical interconnect that passes through the carrier substrate and is electrically coupled to one or more electrical interconnects within the redistribution structure.

Example 6: the device or method of any of Examples 1-5 in which the device die is a first device die and the device package further includes a second device die disposed above the first device die and encapsulated within the volume of molding material, the second device die having a lower surface that faces the upper surface of the first device die, and an electrically conductive interconnect that passes through the volume of molding material and electrically couples an electrical contact on the lower surface of the second die to an electrical contact pad on the upper surface of the first device die.

Example 7: the device or method of any of Examples 1-6 that further includes a carrier substrate having a lower surface and an upper surface opposite the upper surface, the upper surface of the carrier substrate including a set of external electrical interconnects that are exposed at the first surface of the device package, where the lower surface of the carrier substrate is disposed on the volume of molding material above the device die and the redistribution structure, where the carrier substrate includes an aperture that surrounds the connector body, and where the electrical connector is electrically coupled to one or more of the external electrical interconnects via an electrical interconnect that passes through the volume of molding material and is electrically coupled to one or more electrical interconnects within the redistribution structure.

Example 8: the device or method of any of Examples 1-7 where the connector body is a fiber optic connector body configured to be coupled to an optical fiber. Other technical features may be readily apparent to one skilled in the art from the following figures, descriptions, and claims.

Example 9: the device or method of any of Examples 1-8 where the connector body is electrically coupled to the device die via an electrical interconnect that is exposed at the upper surface of the redistribution structure and passes through the first RDL and the second RDL.

Example 10: the device or method of any of Examples 1-9 where the first RDL is characterized by a first elastic modulus and the second RDL is characterized by a second elastic modulus that is lower than the first elastic modulus.

Example 11: The device or method of any of Examples 1-10 where the device die is a first device die and the device package further includes a second device die disposed above the first device die and encapsulated within the volume of molding material, the second device die having a lower surface that faces the upper surface of the first device die, and an electrically conductive interconnect that passes through the volume of molding material and electrically couples an electrical contact pad on the lower surface of the second die to an electrical contact pad on the upper surface of the carrier substrate.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

## Claims

1. An electronic device package comprising:
a device die having an upper surface and a lower surface;
a redistribution structure disposed on the upper surface of the device die, the redistribution structure including one or more redistribution layers (RDLs) formed from electrically insulating material and having electrical interconnects routed within them;
a connector body disposed above the die and bonded to the redistribution structure; and
a volume of molding material which encapsulates the die and the redistribution structure and surrounds lower portion of the connector body such that an upper portion of the connector body is exposed at a first surface of the device package.

2. The electronic device package of claim 1, wherein the connector body is an electrical connector configured to be coupled to a coaxial electrical cable.

3. The electronic device package of claim 1 or 2, wherein the redistribution structure comprises a first RDL disposed on the upper surface of the device die and a second RDL disposed between the first RDL and the connector body.

4. The electronic device package of claim 3, wherein the connector body is electrically coupled to the device die via an electrical interconnect that is exposed at the upper surface of the redistribution structure and passes through the first RDL and the second RDL.

5. The electronic device package of claim 3, wherein the first RDL is **characterized by** a first elastic modulus and the second RDL is **characterized by** a second elastic modulus that is lower than the first elastic modulus.

6. The electronic device package according to any preceding claims, wherein the lower portion of the connector body is encapsulated within the volume of molding material.

7. The electronic device package according to any preceding claims, further comprising a carrier substrate having a lower surface and an upper surface opposite the upper surface;
wherein the lower surface of the device die is bonded to the upper surface of the carrier substrate;
wherein the lower surface of the carrier substrate includes a set of external electrical contacts that are exposed at a second surface of the device package; and
wherein the electrical connector is electrically coupled to one or more of the external electrical interconnects via an electrical interconnect that passes through the carrier substrate and is electrically coupled to one or more electrical interconnects within the redistribution structure.

8. The electronic device package according to claim 1 to claim 5, wherein the device die is a first device die and the device package further comprises:
a second device die disposed above the first device die and encapsulated within the volume of molding material, the second device die having a lower surface that faces the upper surface of the first device die; and
an electrically conductive interconnect that passes through the volume of molding material and electrically couples an electrical contact on the lower surface of the second die to an electrical contact pad on the upper surface of the first device die.

9. A method comprising:
bonding a connector body to a redistribution structure above a device die, redistribution structure including one or more redistribution layers (RDLs) formed from electrically insulating material and having electrical interconnects routed within them; and
encapsulating the device die and the redistribution structure within a volume of molding material such that a lower portion of the connector body is surrouned by the volume of molding material and the upper portion of the connector body is exposed at a surface of the device package;
wherein the connector body is an electrical connector configured to be coupled to a coaxial electrical cable or a fiber optic connector configured to be coupled to an optical fiber.

10. The method of claim 9, wherein the redistribution structure comprises a first RDL disposed on the upper surface of the device die and a second RDL disposed between the first RDL and the connector body.

11. The method of claim 10, further comprising electrically coupling the connector body the device die via an electrical interconnect that is exposed at the upper surface of the redistribution structure and passes through the first RDL and the second RDL.

12. The method of claim 10, wherein the first RDL is **characterized by** a first elastic modulus and the second RDL is **characterized by** a second elastic modulus that is lower than the first elastic modulus.

13. The method according to claim 9 to claim 12, further comprising encapsulating the lower portion of the connector body within the volume of molding material.

14. The method according to claim 9 to claim 13, further comprising a carrier substrate having a lower surface and an upper surface opposite the upper surface;
wherein the lower surface of the device die is bonded to the upper surface of the carrier substrate;
wherein the lower surface of the carrier substrate includes a set of external electrical contacts that are exposed at a second surface of the device package; and
wherein the electrical connector is electrically coupled to one or more of the external electrical interconnects via an electrical interconnect that passes through the carrier substrate and is electrically coupled to one or more electrical interconnects within the redistribution structure.

15. The method according to claim 9 to 12 , wherein the device die is a first device die and the device package further comprises:
a second device die disposed above the first device die and encapsulated within the volume of molding material, the second device die having a lower surface that faces the upper surface of the first device die; and
an electrically conductive interconnect that passes through the volume of molding material and electrically couples an electrical contact on the lower surface of the second die to an electrical contact pad on the upper surface of the first device die.
